# EUROPEAN PATENT SPECIFICATION

(11) **EP 2 555 124 B1**
(45) Date of publication and mention of the grant of the patent: **04.03.2015**
(21) Application number: 12178870.7
(22) Date of filing: 01.08.2012
(51) Int. Cl.: G06F 13/40, H03K 19/00

(54) **A device for interfacing to a bidirectional bus line of the I2C type**
Schnittstellen-Vorrichtung für eine bidirektionale Busleitung des Typs I2C
Dispositif d'interfaçage à un bus bidirectionnel de type I2C

(30) Priority: 01.08.2011 IT TO20110714
(43) Date of publication of application: 06.02.2013
(73) Proprietor: Indesit Company S.p.A., 60044 Fabriano (AN) (IT)
(72) Inventor: Possanza, Mauro, I-60044 Fabriano (AN) (IT)
(74) Representative: Dini, Roberto

(56) References cited:
- US-A- 5 689 196
- US-A1- 2008 034 134
- US-A1- 2009 153 193

## Description

### Field of the invention

The present invention relates to a device for interfacing to a bidirectional bus line of the IIC type, also referred to as I2C or through other similar acronyms.

### Background art

In an architecture based upon an I2C communication standard, also called IIC, at least one microprocessor and at least one communication device (e.g. a microprocessor) are connected to each other through a communication bus having two pairs of lines: one for data and one for synchronization. When no device is transmitting, the bus is at a high logic level; vice versa, when the logic level on the bus is low, a device is transmitting.

When a microprocessor drives a low logic level, i.e. it offers low impedance to the communication port, the high-driving currents of the other devices connected to the I2C bus reclose to the communication port of the microprocessor itself. As the number of devices connected to the bus grows, the currents involved at said port grow as well, which implicitly limits the number of devices that can be handled within a single structure.

This problems becomes even more apparent when a long bus needs to be provided, in which case it would be desirable to increase the circulating currents in order to make the structure immune to external electromagnetic noise. Of course, this again translates into increased current at the microprocessor's communication port.

Therefore, it would be desirable to make the value of the current drawn by the microprocessor independent of the number of devices connected to the bus and of the impedance that drives the low logic state, which induces corresponding circulating currents. Another problem that needs to be solved is that the currents involved may reach high values, thus causing thermal drifts that adversely affect the circuits' behaviour, mainly because of high temperature variations in the environment where such circuits have to operate, as is the case of household appliances. For example, in the case of a washing and/or drying machine, the ambient temperature (i.e. the temperature inside the machine, where the circuit is arranged) may change from 0 °C in the installation room (basement or veranda) to 60 °C during a high-temperature wash cycle (90 °C) or during a drying cycle; in the case of a cooking oven, the temperature may vary from an ambient temperature of 15 °C in a kitchen to 80 °C during a cooking cycle of the oven.

US2009/153193 discloses a device according to the preamble of claim 1.

### Summary of the invention

It is one object of the present invention to provide a device for interfacing to a bidirectional bus line of the I2C type which is adapted to limit the currents that reclose to the microprocessor's communication port.

The present invention aims at providing a device for interfacing to a bidirectional bus line of the I2C type which is particularly robust against thermal drifts.

The present invention relates, in accordance with claim 1, to a device for interfacing to a bidirectional bus line of the I2C type, the bus having a first high logic level and a first low logic level, the device including: a first input adapted to be operationally connected to a first reference voltage potential, a second input adapted to be operationally connected to a second supply voltage potential, and a third input adapted to be operationally connected to a third supply voltage potential; the second and third supply potentials having a greater absolute value than said first reference potential; a first pin adapted to be operationally connected to a port of a device adapted to communicate through said I2C bus, and normally kept at a second high logic level defined by said third reference potential; a second pin adapted to be operationally connected to said I2C bus, and normally kept at said first high logic level defined by said second supply potential; switching means comprising an input connection to said second pin, a first control connection, and an output connection to said first reference potential, and adapted to force the second pin at said first reference potential when said first pin is forced at a low logic level; a first diode having an anode connected to the first pin and a cathode connected to the second pin, thus defining a low logic level in reception; drive means for driving said switching means, comprising an input connection operationally connected to said third supply potential and to said control connection, a second control connection operationally connected to said third supply potential and to said first pin, and an output connection connected to said first reference potential; said second control connection of the drive means being operationally connected to said first pin through a second diode, the second diode having an anode connected to the second control connection and a cathode connected to the first pin.

The present invention also relates to an I2C communication structure comprising at least one I2C bus and at least one processing device having at least one port of communication means adapted to communicate through the I2C bus, and characterized by comprising an interface device complying with the present invention.

According to another aspect of the invention, said device is particularly suitable for application when the bus length is considerable and/or when there are a large number of devices connected to the I2C bus, as is the case, for example, of the electronic circuits of a household appliance. The bus length is considerable, for example, when the I2C bus is used for connecting devices located on different electronic boards within the household appliance, e.g. a load control board and a user interface control board, which may be placed at a distance of some tens of centimeters from each other.

It is a particular object of the present invention to provide a device for interfacing to a bidirectional bus line of the I2C type and a household appliance incorporating such a device as clearly set out in the appended claims, which are intended to be an integral part of the present description.

### Brief description of the drawings

Further features and advantages of the invention will become more apparent from the following detailed description of some preferred but non-limiting embodiments of a device for interfacing to a bidirectional bus line of the I2C type, provided merely by way of explanatory and non-limiting example with reference to the annexed drawings, wherein:

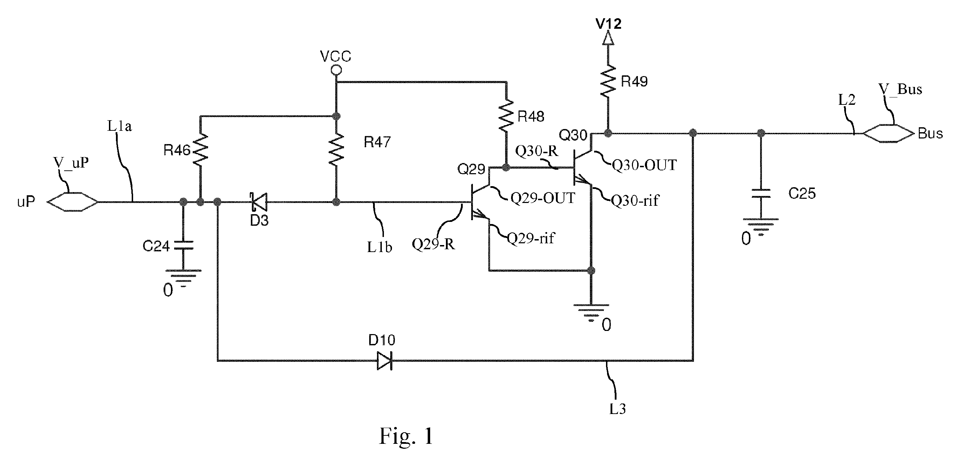

Fig. 1 shows an example of a circuit diagram complying with the present invention.

### Detailed description of an example of embodiment.

With reference to the example of embodiment shown in Fig. 1, a device in accordance with the present invention comprises:
- a first pin uP adapted to be connected to a port of any communication device suitable for communicating through an I2C bus in accordance with the I2C protocol; by way of example, said any device will hereafter be referred to as a microprocessor,
- a second pin Bus adapted to be connected to an I2C bus,
- a diode D3 having the cathode connected to the first pin uP through an electric line Lla,
- a first three-contact switch Q29, preferably a transistor of any kind, i.e. equipped with contacts for: output Q29-OUT, reference Q29-rif and control Q29-R. Said switch is connected to:
   ∘ the anode of the diode D3 for its own control contact Q29-R, through an electric line L1b,
   o a first reference potential 0 for the reference contact Q29-rif,
   o a third supply potential VCC (referring to the reference potential) for said input contact Q29-IN,
   ∘ it is therefore in the emitter follower configuration,
- a second three-contact switch Q30, with respective contacts for: output Q30-OUT, reference Q30-rif and control Q30-R. Said second switch is connected to:
   ∘ the output contact Q29-OUT of the first switch Q29 for its own control contact Q30-R,
   o the first reference potential 0 for its own reference contact Q30-rif,
   o a second supply potential V12 (referring to the reference potential), and to the second pin Bus through its own output contact Q30-OUT,
- a diode D10 having the anode connected to the first pin uP and the cathode connected to the second pin Bus,
- also the electric lines L1a and L1b are supplied by the second reference potential Vcc.

According to a preferred variant of the device, the second supply potential V12 has a value of 12 Volts or anyway a value which is useful to define the high logic level of the IIC bus, e.g. through a pull-up resistor.

The first reference potential 0 is generally an earth or ground reference.

The third supply potential VCC has a greater value than the reference potential 0 and may coincide with V12.

The interface device may be in the following possible states:
- the pin uP and the pin Bus are both kept at a high logic level, respectively V_uP High and V_Bus High: in this condition, either no communication device is transmitting, i.e. all the devices connected to the I2C bus are receiving, or the microprocessor connected to the pin uP is transmitting at a high level;
- the pin uP is not driven by the respective microprocessor, since the communication port is set to reception, while the pin Bus is driven to a low logic level V_Bus Low: this means that the microprocessor connected to the pin uP is receiving data from another device connected to the I2C bus, which is driving its own port to V_uP Low, thereby also setting the bus to the low logic level V_Bus Low;
- the pin uP is driven to a low logic level V_uP Low by the respective microprocessor, which is transmitting data; this means that there is low impedance at the communication port of the microprocessor, while the other devices (those communicating) are in reception (by keeping high impedance at their own communication ports with respective V_uP High).

In the first case of said operating conditions, when the logic level V_bus is high, also the logic level of the pin uP is high, since the microprocessor has high impedance at the communication port. The pin uP is then at a logic level substantially equal to VCC. Said potential value VCC, which is common to the control contact Q29-R of the first switch Q29, sets the same switch Q29 to conduction (ON). Therefore, the potential of the output contact Q29-OUT and hence that of the control contact Q30-R go almost to the first reference potential 0, i.e. the ground potential, plus the voltage drop at the first switch Q29. The second switch Q30 is thus inhibited (OFF), i.e. non-conducting.

When the microprocessor is in reception mode while another device is in transmission mode, i.e. at a low logic level, the first pin uP is at a potential equal to the sum of the potential of the second pin Bus and the voltage drop at the diode D10. Said level, equal to approx. 0.7 V, is recognized as a low logic level in reception. In such a circumstance, the potential of the control contact Q29-R of the first switch Q29 is equal to the potential of the first pin uP plus the voltage drop at the diode D3, i.e. it is equal to approx. 1.0 V. Such a potential is sufficient to hold the first switch Q29 in conduction (ON) and therefore to keep inhibited (OFF) the second switch Q30, as described above. This ensures that no "latching" phenomena can arise, i.e. that the presence of a low logic level on the bus, generated by another transmitting device, may turn on the transistor Q30. The interface device must ensure that the transistor Q30 will only turn on when a low level is transmitted by the associated microcontroller.

As previously explained, the microprocessor perceives potential variations at its own communication port between a high logic level, e.g. 3.3V (≈VCC) and a low potential, equal to the voltage drop at D10 plus the potential of the second pin, following corresponding logic level variations on the bus line.

When the microprocessor connected to the pin uP wants to transmit, it drives the pin uP to a low logic level. The potential at the control contact Q29-R of the first switch Q29 is given by the sum of the potential of the pin uP and the voltage drop at the diode D3, which is equal to approx. 0.3 V, i.e. insufficient to set the first switch Q29 to conduction; Q29 being thus inhibited (OFF), the control contact Q30-R of the second switch is substantially at the same potential as VCC, and therefore the second switch Q30 is conducting (ON), thereby setting the second pin Bus to a potential close to the reference potential 0, i.e. the Bus is at a potential equal to the reference potential 0 plus the voltage drop at the second switch Q30. The potential variation on the I2C bus will thus be perceived by the other devices connected to the I2C bus.

It is preferable that the third potential VCC is connected to the electric line L1a through a resistor R46, to the electric line L1b through a resistor R47, and to the output contact Q29-OUT and control contact Q30-R through a resistor R48.

It is also preferable that the second supply reference potential V12 is connected to the second pin Bus through a resistor R49.

Furthermore, it is preferable that the line L1a is connected to the reference potential 0 through a filter capacitor C24, and that the second pin Bus is connected to the reference potential 0 through another filter capacitor C25.

The preferred values of such components are as follows:
R46 = 47*k*Ω
R47 = 47*k*Ω
R48 = 10 *k*Ω
R49 = 1 *k*Ω
C24 = 10pF
C25 = 220pF
D10 is of the D1n4148 type
D3 is of the Schottky type, preferably BAT54

The switches may be transistors of whatever nature. The use of NPN transistors or of different transistors is within the grasp of the man skilled in the art.

With reference to the complete diagram of Fig. 1, when the microprocessor is driving the pin uP to a high logic level, the potential of uP is substantially equal to VCC, which causes Q29 to be turned on by the current generated by the potential VCC through R47; as a result, Q30 is inhibited and the voltage on the bus line reaches the direct voltage ofV12, i.e. 12 V, through the pull-up resistor R49, provided that no device connected to the bus is in transmission mode, i.e. is driving a low logic level on the bus I2C.

The microprocessor may be of the 5V or 3.3V type or of a different type. The device can be adapted to the microprocessor simply by changing VCC or the pull-up resistor R46.

One of the peculiarities of the circuit is that the operation of the transistor Q29 remains stable as temperature changes. When the microprocessor is transmitting a low logic level, as aforesaid, Q29 must remain inhibited: a possible decrease of the base-emitter threshold voltage of Q29 due to an increase of temperature will not cause Q29 to go on because it will be compensated for by a corresponding reduction of the voltage at the diode D3. On the other hand, when the microprocessor is receiving a low logic level present on the pin Bus, as aforesaid, Q29 must stay in conduction: a possible increase of the base-emitter threshold voltage of Q29 due to a lower temperature will not cause Q29 to be inhibited because it will be compensated for by a corresponding increase of the voltage drop at the diodes D3 and D10.

An I2C architecture based on the present invention comprises at least one communication bus, at least one microprocessor, and at least one further device, both of which are connected to the I2C bus through a respective interface device complying with the present invention.

The use of such an interface device is transparent to the devices connected to the I2C bus, which, when driving a high or low logic level, etc., want to drive the I2C bus, although the latter is actually driven indirectly through the above-described interface device. Advantageously, the device of the present invention comprises connection means Q30 for setting the second pin Bus to a low logic level, which substantially is a potential close to the reference potential 0, when the microprocessor is driving a low logic level in order to transmit data.

In this manner, the high-driving currents of the other devices connected to the I2C bus reclose through the transistor Q30, not to the microprocessor's port, which sends data signals on the bus through the diode D10, the latter allowing this data transmission without allowing any currents to flow from the bus to the microprocessor's port.

When a port of a microprocessor is connected to multiple I2C buses, as many interface devices can be interposed between the microprocessor's port and the respective buses.

The above-described embodiment example may be subject to variations without departing from the protection scope of the present invention, including all equivalent designs known to a man skilled in the art.

From the above description, those skilled in the art can produce the object of the invention without introducing any further construction details.

## Claims

1. An interfacing device to a bidirectional bus line of the I2C type, the bus being adapted to take a first high logic level (V_Bus High) and a first low logic level (V_Bus Low),
the device including:
- a first input adapted to be operationally connected to a first reference potential (0),
- a second input adapted to be operationally connected to a second supply potential (V12), and
- a third input adapted to be operationally connected to a third supply potential (VCC), the second and third supply potentials (V12, VCC) having a greater absolute value than said first reference potential (0),
- a first pin (uP) adapted to be operationally connected to a port of a device adapted to communicate through said I2C bus, and normally kept at a second high logic level (V_uP High) defined by said third reference potential (VCC),
- a second pin (Bus) adapted to be operationally connected to said I2C bus, and normally kept at said first high logic level (V_Bus High) defined by said second supply potential (V12),
**characterised by**
- switching means (Q30) comprising an output connection (Q30-OUT) to said second pin (Bus), a first control connection (Q30-R), and a reference connection (Q30-rif) to said first reference potential (0), and adapted to force the second pin (Bus) to said first reference potential (0) when said first pin (uP) is forced to a low logic level,
- a first diode (D10) having an anode connected to the first pin (uP) and a cathode connected to the second pin (Bus), and adapted to generate a low logic level in reception on the first pin (uP) in the presence of the low logic level on the bus,
- drive means (Q29) for driving said switching means (Q30), comprising an output connection (Q29-OUT) operationally connected to said third supply potential (VCC) and to said control connection (Q30-R), a second control connection (Q29-R) operationally connected to said third supply potential (VCC) and to said first pin (uP), and a reference connection (Q29-RIF) to said first reference potential (0),
- said second control connection (Q29-R) of the drive means (Q29) being operationally connected to said first pin (uP) through a second diode (D3), the second diode (D3) having an anode connected to the second control connection (Q29-R) and a cathode connected to the first pin (uP).

2. A device according to claim 1, wherein:
- said second control connection (Q29-R) of the drive means (Q29) is connected to said third supply potential (VCC) through a first resistor (R47);
- said output connection (Q29-OUT) of the drive means (Q29) is connected to said third supply potential (VCC) through a second resistor (R48);
- said first pin (uP) is connected to said third supply potential (VCC) through a third resistor (R46);
- said second pin (Bus) is connected to said second supply potential (V12) through a fourth resistor (R49).

3. A device according to claim 1 or 2, further comprising a first capacitor (C24) that connects said first pin (uP) to said first reference potential (0) and/or a second capacitor (C25) that connects said second pin (Bus) to said first reference potential (0).

4. A device according to claim 1, wherein said second diode (D3) is of the Schottky type.

5. A device according to claim 3, wherein said first resistor (R47) has a resistance value of 47 *k*Ω and/or
said second resistor (R48) has a resistance value of 10 *k*Ω and/or
said third resistor (R46) has a resistance value of 47 *k*Ω and/or
said fourth resistor (R49) has a resistance value of 1 *k*Ω and/or
said first capacitor (C24) has a capacity value of 10pF and/or
said second capacitor (C25) has a capacity value of 220pF.

6. An I2C communication structure comprising at least one I2C bus and at least one processing device having at least one port of communication means adapted to communicate through the I2C bus, and **characterized by** comprising an interface device according to any one of the preceding claims.

7. A household appliance comprising a device according to any one of claims 1 to 5 and/or comprising an I2C communication structure according to claim 6.

8. A washing and/or drying machine comprising a device according to any one of claims 1 to 5 and/or comprising an I2C communication structure according to claim 6.

9. A cooking oven comprising a device according to any one of claims 1 to 5 and/or comprising an I2C communication structure according to claim 6.

## Patentansprüche

1. Schnittstellen-Vorrichtung für eine bi-direktionale Busleitung vom I2C-Typ, wobei der Bus angepasst ist, einen ersten hohen logischen Pegel (V_Bus High) und einen ersten niedrigen logischen Pegel (V_Bus Low) anzunehmen, wobei die Vorrichtung beinhaltet:
- einen ersten Eingang, der angepasst ist, operativ mit einem ersten Bezugspotential (0) verbunden zu werden,
- einen zweiten Eingang, der angepasst ist, operativ mit einem zweiten Versorgungspotential (V12) verbunden zu werden, und
- einen dritten Eingang, der angepasst ist, operativ mit einem dritten Versorgungspotential (VCC) verbunden zu werden, wobei die zweiten und dritten Versorgungspotentiale (V12, VCC) einen größeren Absolutwert aufweisen als das erste Bezugspotential (0),
- einen ersten Anschluss (uP), der angepasst ist, operativ mit einem Port einer Vorrichtung, die angepasst ist, über den 12C-Bus zu kommunizieren, verbunden zu werden, und der normalerweise auf einem zweiten hohen logischen Pegel (V_uP High), der durch das dritte Bezugspotential (VCC) definiert wird, gehalten wird,
- einen zweiten Anschluss (Bus), der angepasst ist, operativ mit dem 12C-Bus verbunden zu werden, und der normalerweise bei dem ersten hohen logischen Pegel (V_Bus High), der durch das zweite Versorgungspotential (V12) definiert wird, gehalten wird,
**gekennzeichnet durch**
- Schaltmittel (Q30), die eine Ausgangsverbindung (Q30-OUT) zu dem zweiten Anschluss (Bus), eine erste Steuerverbindung (Q30-R) und eine Bezugsverbindung (Q30-rif) zu dem ersten Bezugspotential (0) umfassen, und die angepasst sind, den zweiten Anschluss (Bus) auf das erste Bezugspotential (0) zu zwingen, wenn der erste Anschluss (uP) auf einen niedrigen logischen Pegel gezwungen wird,
- eine erste Diode (D10), die eine Anode, die mit dem ersten Anschluss (uP) verbunden ist, und eine Kathode, die mit dem zweiten Anschluss (Bus) verbunden ist, aufweist, und die angepasst ist, einen niedrigen logischen Pegel im Empfang auf den ersten Anschluss (uP) beim Vorhandensein des niedrigen logischen Pegels auf dem Bus zu erzeugen,
- Ansteuermittel (Q29) zum Ansteuern der Schaltmittel (Q30), umfassend eine Ausgangsverbindung (Q29-OUT), die operativ mit dem dritten Versorgungspotential (VCC) und der Steuerverbindung (Q30-R) verbunden ist, eine zweite Steuerverbindung (Q29-R), die operativ mit dem dritten Versorgungspotential (VCC) und dem ersten Anschluss (uP) verbunden ist, und eine Bezugsverbindung (Q29-RIF) zu dem ersten Bezugspotential (0),
- wobei die zweite Steuerverbindung (Q29-R) der Ansteuermittel (Q29) über eine zweite Diode (D3) operativ mit dem ersten Anschluss (uP) verbunden ist, wobei die zweite Diode (D3) eine Anode, die mit der zweiten Steuerverbindung (Q29-R) verbunden ist, und eine Kathode, die mit dem ersten Anschluss (uP) verbunden ist, aufweist.

2. Vorrichtung nach Anspruch 1, wobei:
- die zweite Steuerverbindung (Q29-R) der Schaltmittel (Q29) mit dem dritten Versorgungspotential (VCC) über einen ersten Widerstand (R47) verbunden ist;
- die Ausgangsverbindung (Q29-OUT) der Umschaltmittel (Q29) mit dem dritten Versorgungspotential (VCC) über einen zweiten Widerstand (R48) verbunden ist;
- der erste Anschluss (uP) mit dem dritten Versorgungspotential (VCC) über einen dritten Widerstand (R46) verbunden ist;
- der zweite Anschluss (Bus) mit dem zweiten Versorgungspotential (V12) über einen vierten Widerstand (R49) verbunden ist.

3. Vorrichtung nach Anspruch 1 oder 2, des Weiteren umfassend einen ersten Kondensator (C24), der den ersten Anschluss (uP) mit dem ersten Bezugspotential (0) verbindet, und/oder einen zweiten Kondensator (C25), der den zweiten Anschluss (Bus) mit dem ersten Bezugspotential (0) verbindet.

4. Vorrichtung nach Anspruch 1, wobei die zweite Diode (D3) vom Schottky-Typ ist.

5. Vorrichtung nach Anspruch 3, wobei
der erste Widerstand (R47) einen Widerstandswert von 47 kΩ aufweist und/oder
der zweite Widerstand (R48) einen Widerstandswert von 10 kΩ aufweist und/oder
der dritte Widerstand (R46) einen Widerstandswert von 47 kΩ aufweist und/oder
der vierte Widerstand (R49) einen Widerstandswert von 1 kΩ aufweist und/oder
der erste Kondensator (C24) einen Kapazitätswert von 10 pF aufweist und/oder
der zweite Kondensator (C25) einen Kapazitätswert von 220 pF aufweist.

6. I2C-Kommunikationsstruktur, umfassend zumindest einen I2C-Bus und zumindest eine Verarbeitungsvorrichtung, die zumindest einen Port von Kommunikationsmitteln aufweist, die angepasst sind, über den I2C-Bus zu kommunizieren, **dadurch gekennzeichnet, dass** die Struktur eine Schnittstellen-Vorrichtung nach einem der vorangegangenen Ansprüche umfasst.

7. Haushaltsgerät, umfassend eine Vorrichtung nach einem der Ansprüche 1 bis 5 und/oder umfassend eine I2C-Kommunikationsstruktur nach Anspruch 6.

8. Wasch- und/oder Trocknungsmaschine, umfassend eine Vorrichtung nach einem der Ansprüche 1 bis 5 und/oder umfassend eine I2C-Kommunikationsstruktur nach Anspruch 6.

9. Backofen, umfassend eine Vorrichtung nach einem der Ansprüche 1 bis 5 und/oder umfassend eine I2C-Kommunikationsstruktur nach Anspruch 6.

## Revendications

1. Dispositif d'interfaçage à une ligne de bus bidirectionnelle du type I2C, le bus étant agencé pour prendre un premier niveau logique haut (V_Bus_High) et un premier niveau logique bas (V_Bus_Low), le dispositif comprenant :
- une première entrée agencée pour être reliée fonctionnellement à un premier potentiel de référence (0),
- une deuxième entrée agencée pour être reliée fonctionnellement à un deuxième potentiel d'alimentation (V12), et
- une troisième entrée agencée pour être reliée fonctionnellement à un troisième potentiel d'alimentation (VCC),
les deuxième et troisième potentiels d'alimentation (V12, VCC) ayant une valeur absolue supérieure à celle dudit premier potentiel de référence (0),
- une première broche (uP) agencée pour être reliée fonctionnellement à un port d'un dispositif agencé pour communiquer par le biais dudit bus I2C, et maintenue normalement à un deuxième niveau logique haut (V_uP High) défini par ledit troisième potentiel de référence (VCC),
- une deuxième broche (Bus) agencée pour être reliée fonctionnellement audit bus I2C, et maintenue normalement audit premier niveau logique haut (V_bus High) défini par ledit deuxième potentiel d'alimentation (V12),
**caractérisé par**
- des moyens de commutation (Q30) comprenant une borne de sortie (Q30-OUT) reliée à ladite deuxième broche (Bus), une première borne de commande (Q30-R), et une borne de référence (Q30-rif) audit premier potentiel de référence (0), et agencés pour forcer la deuxième broche (Bus) audit premier potentiel de référence (0) lorsque ladite première broche (uP) est forcée à un niveau logique bas,
- une première diode (D10) comportant une anode reliée à la première broche (uP) et une cathode reliée à la deuxième broche (Bus), et agencée pour générer un niveau logique bas en réception sur la première broche (uP) en présence du niveau logique bas sur le bus,
- des moyens de commande (Q29) destinés à commander lesdits moyens de commutation (Q30), comprenant une borne de sortie (Q29-OUT) reliée fonctionnellement audit troisième potentiel d'alimentation (VCC) et à ladite borne de commande (Q30-R), une deuxième borne de commande (Q29-R) reliée fonctionnellement audit troisième potentiel d'alimentation (VCC) et à ladite première broche (uP), et une borne de référence (Q29-RIF) audit premier potentiel de référence (0),
- ladite deuxième borne de commande (Q29-R) des moyens de commande (Q29) étant reliée fonctionnellement à ladite première broche (uP) par le biais d'une deuxième diode (D3), la deuxième diode (D3) comportant une anode reliée à la deuxième borne de commande (Q29-R) et une cathode reliée à la première broche (uP).

2. Dispositif selon la revendication 1, dans lequel :
- ladite deuxième borne de commande (Q29-R) des moyens de commande (Q29) est reliée audit troisième potentiel d'alimentation (VCC) par le biais d'une première résistance (R47) ;
- ladite borne de sortie (Q29-OUT) des moyens de commande (Q29) est reliée audit troisième potentiel d'alimentation (VCC) par le biais d'une deuxième résistance (R48) ;
- ladite première broche (uP) est reliée audit troisième potentiel d'alimentation (VCC) par le biais d'une troisième résistance (R46) ;
- ladite deuxième broche (Bus) est reliée audit deuxième potentiel d'alimentation (V12) par le biais d'une quatrième résistance (R49).

3. Dispositif selon la revendication 1 ou 2, comprenant en outre un premier condensateur (C24) qui relie ladite première broche (uP) audit premier potentiel de référence (0) et/ou un deuxième condensateur (C25) qui relie ladite deuxième broche (Bus) audit premier potentiel de référence (0).

4. Dispositif selon la revendication 1, dans lequel ladite deuxième diode (D3) est du type Schottky.

5. Dispositif selon la revendication 3, dans lequel ladite première résistance (R47) a une valeur de résistance de 47 kΩ et/ou
ladite deuxième résistance (R48) a une valeur de résistance de 10 kΩ et/ou
ladite troisième résistance (R46) a une valeur de résistance de 47 kΩ et/ou
ladite quatrième résistance (R49) a une valeur de résistance de 1 kΩ et/ou
ledit premier condensateur (C24) a une valeur de capacité de 10 pF et/ou
ledit deuxième condensateur (C25) a une valeur de capacité de 220 pF.

6. Structure de communication I2C comprenant au moins un bus I2C et au moins un dispositif de traitement comportant au moins un port de moyens de communication agencés pour communiquer par le biais du bus I2C, et **caractérisée en ce qu'**elle comprend un dispositif d'interfaçage selon l'une quelconque des revendications précédentes.

7. Appareil ménager comprenant un dispositif selon l'une quelconque des revendications 1 à 5 et/ou comprenant une structure de communication I2C selon la revendication 6.

8. Lave-linge et/ou sèche-linge comprenant un dispositif selon l'une quelconque des revendications 1 à 5 et/ou comprenant une structure de communication I2C selon la revendication 6.

9. Four de cuisson comprenant un dispositif selon l'une quelconque des revendications 1 à 5 et/ou comprenant une structure de communication I2C selon la revendication 6.
